# EUROPEAN PATENT SPECIFICATION

(11) **EP 4 244 887 B1**
(45) Date of publication and mention of the grant of the patent: **07.10.2026**
(21) Application number: 21895865.0
(22) Date of filing: 17.11.2021
(51) Int. Cl.: H10W 40/25, H10W 40/70, H10W 40/22

(54) **DIAMOND-BASED THERMAL COOLING DEVICES METHODS AND MATERIALS**
THERMISCHE KÜHLVORRICHTUNGEN AUF DIAMANTBASIS, VERFAHREN UND MATERIALIEN
PROCÉDÉS, DISPOSITIFS ET MATÉRIAUX DE REFROIDISSEMENT THERMIQUE À BASE DE DIAMANT

(30) Priority: 18.11.2020 US 202063115116 P
(43) Date of publication of application: 20.09.2023
(73) Proprietor: Sharfi, Benjamin K., Rancho Cucamonga, California 91730 (US)
(72) Inventor: HEMAWAN, Kadek W., Rancho Cucamonga, California 91730 (US); GONZALEZ, Saul, Rancho Cucamonga, California 91730 (US); SHARFI, Benjamin K., Rancho Cucamonga, California 91730 (US)
(74) Representative: FRKelly
(86) International application number: PCT/US2021/072450
(87) International publication number: WO 2022/109552

(56) References cited:
- US-A- 5 751 062
- US-A1- 2002 145 194
- US-A1- 2004 175 875
- US-A1- 2004 175 875
- US-A1- 2005 228 097
- US-A1- 2005 228 097
- US-A1- 2007 295 496
- US-A1- 2009 140 417
- US-A1- 2010 102 442
- US-A1- 2010 193 943
- US-A1- 2010 319 900
- US-A1- 2017 162 467
- US-A1- 2019 074 236

## Description

### TECHNICAL FIELD

The present invention relates to thermal management of electronic devices and other heat-sensitive equipment. More specifically, the present invention relates to novel diamond-based devices, methods, and materials for use in thermal interface cooling. High-quality diamond-based materials, mounted in close thermal proximity to semiconductor components, provide efficient, rapid, and uniform heat distribution and eliminate areas of heat concentration.

### BACKGROUND ART AND SUMMARY OF INVENTION

As an integrated circuit (IC) package becomes smaller, the device power density and operating temperature will increase, thus it demands better thermal management solutions. Efficient heat transfer is very crucial in preventing overheating and in maintaining high-speed performance of the system. Dissipating highly localized heat flux on the IC requires an effective heat spreader material. In particular, the thermal resistance at the material interface must be minimized.

In semiconductors, thermal resistance is a measure of the IC package's heat dissipation capability from a die's active surface (junction) to a specified reference point (package, board, ambient). Thinner material with higher thermal conductivity will lead to lower thermal resistance. The lower the thermal resistance, the better the heat transfer within electronic devices.

Accordingly, thermal resistance is a major consideration in thermal management systems, and it is highest at the contact surfaces, or junctions, where materials are joined or mated. Mated surfaces may have pockets or void spaces due to surface irregularities or roughness that can entrapped air. Since air is a relatively poor conductor with high thermal resistance, this may result in reduction of heat transfer efficiency, overheating, and degraded electronic circuit performance.

Traditional thermal interface materials ("TIM") such as gap pads, epoxy, thermal grease, and other thermal compound in general have poor thermal properties. These TIM are commonly used to attach the semiconductor die to the metal heat spreaders or heat sinks. In order to have efficient heat transfer from the central processing unit (CPU) to the metal surface, the thermal resistance at the interface must be reduced.

Diamond is an electrically insulating material with a very high thermal conductivity > 2200 W/m-K, low heat capacity ~ 1.78 J/cm3K and very low thermal expansion ~1.0 x10-6 K-1. The heat in diamonds is conducted via lattice vibration (phonons) instead of electron flow, transported laterally in all directions, and not stored within the material. Because of these exceptional properties, diamond outperforms today's common heat sink and heat spreader materials such as copper, aluminum, and silicon carbide by factors of 5 to 10 times. Moreover, lab grown diamond is now readily commercially available in different thermal, optical, and electronic grades.

US2004/175875A1 relates to a diamond composite heat spreader having thermal conductivity gradients. US2005/228097 A1 relates to thermally conductive compositions and methods of making thereof. US2010/102442A1 relates to a heat spreader having a single layer of diamond particles. US2007/295496A1 relates to a diamond composite heat spreader. US5751062A relates to a cooling device of a multi-chip module.

One aspect of the present invention provides a freestanding spreader comprising diamond material. The spreader is, in one example, disposed between a central processing unit, or other semiconductor chip for which thermal management is desired, and a traditional metal heat spreader or heat sink.

Another aspect of the present invention provides a liquefied diamond thermal interface paste material. The novel paste material can be utilized to fill gaps in metal heat spreaders or metal heat sinks to improve their cooling performance.

The invention of the claims provides for a nano crystalline diamond thin layer encapsulation on the surface of heat spreaders or heat sinks that enhance heat transfer from the processor die to ambient or base temperature thereby protect the electronic devices from failure.

Finally, the present invention provides various possible combinations of the disclosed freestanding spreader, liquefied diamond thermal interface paste material, and/or nano crystalline diamond thin layer coating to achieve extraordinary cooling performance.

### BRIEF DESCRIPTION OF THE DRAWINGS

**FIG. 1** shows an exploded view of a printed circuit board ("PCB"), CPU, diamond wafer heat spreader, metal heat spreader, fins, and metal heat sink base, in accordance with an embodiment of the present invention.
**FIG. 2** shows an exploded view of a CPU, or other heat source, liquefied diamond thermal interface material coolant, metal foil, diamond wafer heat spreader, and thermal solution device such as metal heat spreader, and metal heat sink base, in accordance with an embodiment of the present invention.
**FIGS. 3-5** show experimental temperature change data for embodiments of the present invention utilizing diamond heat spreaders under different conditions.
**FIG. 6** shows a schematic representation of an assembly interface between two thermal solution devices, such as metal heat spreaders and metal heat sinks, utilizing a liquefied diamond TIM coolant within the fins between them in accordance with an embodiment of the present invention.
**FIG. 7** shows a schematic representation of various patterns for filling voids between devices with liquified diamond TIM coolant in accordance with embodiments of the present invention.
**FIGS. 8-9** show experimental temperature change data for embodiments of the present invention utilizing liquefied diamond TIM coolant under different conditions.
**FIG. 10** shows an exploded view of a PCB board, CPU, nano crystalline diamond coated metal heat spreader, and metal heat sink base, in accordance with an embodiment of the present invention.
**FIG. 11** shows a schematic representation of an assembly interface between a CPU or other heat source, and a thermal solution device, such as a metal heat spreader or a metal heat sink, utilizing a layer of liquefied diamond TIM coolant and a nano crystalline diamond coating layer in accordance with an embodiment of the present invention.

### DESCRIPTION OF EMBODIMENTS

Following are detailed descriptions of three different aspects of the present invention, all of which relate to novel diamond-based devices, methods, and materials for use in thermal interface cooling. The disclosed devices and materials, mounted in close thermal proximity to semiconductor components, provide efficient, rapid, and uniform heat distribution and eliminate areas of heat concentration.

### Freestanding Diamond Wafer Heat Spreader Cooling Thermal Management and Associated Methods

In the present invention, a diamond wafer heat spreader enables electronic system operation at extreme temperatures, enhances heat removal efficiency, increases performance, extends device lifetime, reduces the need for an auxiliary cooling system, and decreased the weight, and footprint of cooling devices.

The freestanding, or stand-alone, diamond wafer heat spreader can be made of any type of diamond such as natural, lab grown poly-crystalline, or lab grown mono-crystal diamonds wafer with varying sizes, thicknesses, and surface smoothness. Lab grown in the present invention refers to diamonds which are synthetically fabricated via microwave plasma chemical vapor deposition (MPCVD).

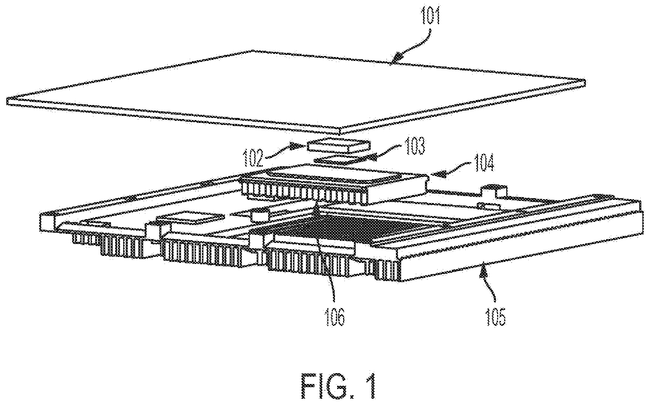

**FIG. 1** shows an example of the schematic configuration (exploded view) between a printed circuit board ("PCB") (101), CPU (102), diamond wafer heat spreader (103), metal heat spreader (104), and metal heat sink base (105).

The diamond wafer heat spreader is ultra-tough, electrically non-conductive, with thickness of less 1 mm or less, having similar footprint to the CPU. The diamond wafer heat spreader (103) is mounted between the CPU (102) and the metal heat spreader (104). The illustrated direct attachment of the diamond wafer heat spreader (103) to the surface of the CPU (102) is novel in that it requires no soldering or brazing metallization on the material interface layer for bonding the two materials. The diamond wafer heat spreader (103) can be surface-mounted on a flat metal heat spreader (104), as shown. Optionally, the metal heat spreader (104) may include an indentation or pocket corresponding to the dimensions of the diamond wafer heat spreader (103) where the diamond wafer heat spreader (103) can be embedded, allowing a more compact configuration.

Another novel aspect of this invention is the selection of diamond surface roughness. The surface finish of the freestanding diamond wafer heat spreader is polished to an average roughness of 20 nm or less. Having a smooth diamond surface decreases the thermal resistance of the diamond wafer heat spreader. Also, the thermal conductivity of the diamond wafer heat spreader is greater than 2,000 W/m-K which is about ten times that of aluminum. Furthermore, the diamond is optically transparent with low impurities and contains very low nitrogen concentration in ppm level within the bulk of the diamond crystal.

The metal heat spreader (104), and metal heat sink base (105) can be made of aluminum, copper, and similar alloy metal materials. The metal heat spreader (104), and metal heat sink base (105) are connected by cooperating fins (106) with large surface area and hybrid thermal interface material (not shown) with high thermal conductivity.

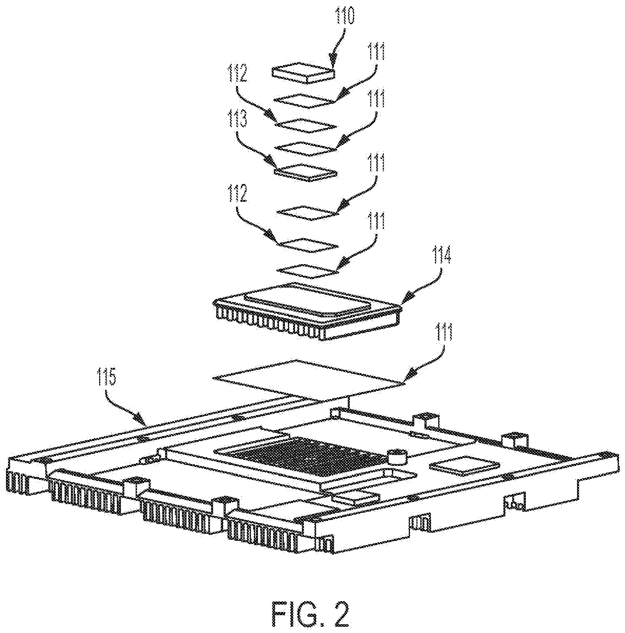

**FIG. 2** shows an additional embodiment of the present invention. Shown a schematic configuration exploded view including a CPU or other heat source (110), layers of liquefied diamond thermal interface material ("TIM") coolant (111), layers of metal foil (112), a diamond wafer heat spreader (113), and one or more thermal solution devices, such as a metal heat spreader (114), and metal heat sink base (115).

The diamond wafer heat spreader (113) is attached between the CPU or other heat source (110) and a metal heat spreader (114) by using thin layers of metal foil (112) and layers of liquefied diamond thermal interface material ("TIM") coolant (111) with thickness of 100 microns or less. The thermal interface material coolant (111) applied in this invention is unique because it comprises a novel combination of liquid metals and solid thermal compounds, such as indium, artic silver, and diamond microparticles with very high thermal conductivity, and no electrical conductivity.

### Temperature Delta Measurements (Freestanding Diamond Wafer)

Temperature delta is a measure of heat transfer efficiency. It is the temperature difference between the CPU core temperature and base temperature. The incorporation of the above-described freestanding diamond heat spreaders within the electronic components, significantly improves thermal cooling and heat dissipation of the system.

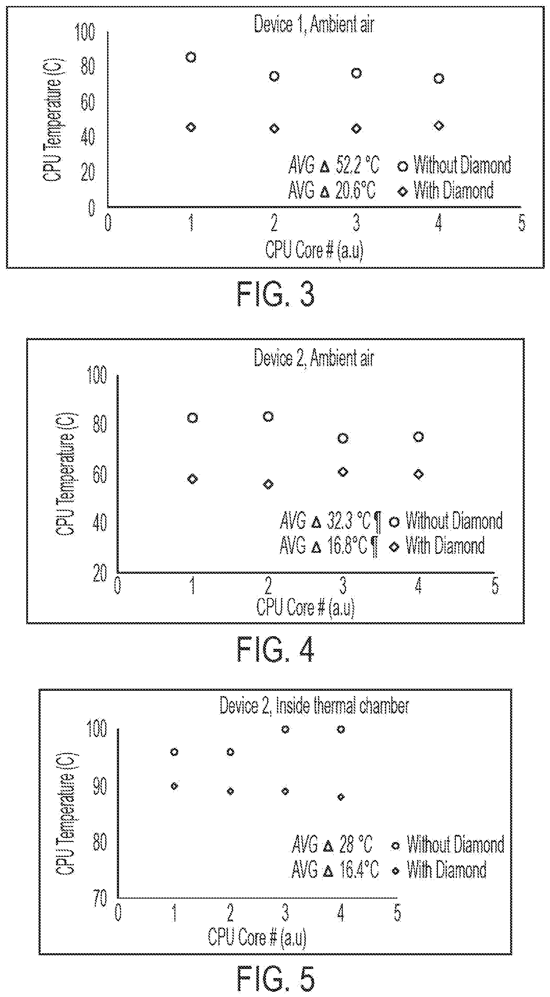

Shown in **FIGS. 3-5** is experimental data at ambient room temperature (**FIGS. 3** and **4**) and in a thermal chamber (**FIG. 5**) showing the effect of applying a freestanding diamond wafer between the CPU and the heat spreader. As can be seen from the figures, the CPU core temperatures drop significantly from average of 52.3 °C to 20.6 °C and 32.3 °C to 16.8 °C for devices in ambient air.

Test inside a thermal chamber (oven) with base temperature of 75 °C results in the average temperature delta drops from 28 °C to 16 °C. The CPU core temperatures inside the oven are higher compared to the room temperature due to the increase in the ambient base temperature inside the oven.

### Liquefied Diamond Thermal Interface Material Coolant and Method for Use

An additional embodiment of the present invention relates to thermal management of electronic devices by combining solid diamond powder and liquid metals into a thermal interface material ("TIM") coolant in the form of a thermally conductive paste.

The liquefied diamond thermal interface material coolant paste comprises of solute and solvent which are diamond micro powder and liquid metal respectively. The mixing is attained by combining amounts of solvent and solute together inside a container at room temperature and then stirring them mechanically by hand to form a paste or coolant without any sintering or electroplating process.

In order to achieve the combination of high thermal performance and viscosity, preferably at least 20 weight percent (wt. %) of diamond particles solute mixed into the liquid metal solvent to form a coolant paste. The higher the weight percentage, the higher the thermal performance of the liquefied diamond thermal interface material coolant.

The liquefied diamond thermal interface material coolant is highly conformable, spreadable, and electrically insulating, which is very critical for electrical traces, vias, and leads in electronic circuitry. Liquefied diamond TIM coolant can be applied to various shapes of thermal solution device where thermal resistance is high at the contact surfaces or junctions where materials are joined.

Unlike solder, which requires heating during use, the liquefied diamond thermal interface material coolant is very easy to use and apply on metal surface. It is applied in one stage by brushing or rubbing thin layer the liquefied diamond thermal interface material coolant on the surface of the metal heat spreader or metal heat sink base fins.

The diamond powder can be derived from natural or synthetic diamonds and have particle size within a range of approximately 0.1 micron to approximately 10 microns. The composition of the liquid metal can include but are not limited to high density silver thermal compound, thermal grease, and/or a phase-change material. The materials of the heat sink and heat spreader can be copper, aluminum, molybdenum, platinum, titanium, tungsten, chromium, iron, and other refractory metals or alloys thereof. The metal heat spreader may have metallized coating such as platinum, titanium, gold, nickel to provide better thermal contact and thus facilitating heat transfer within the device.

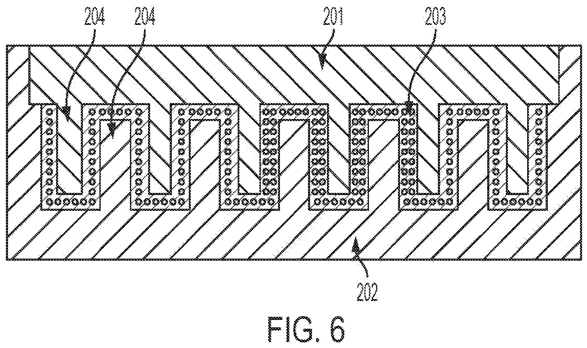

Shown in **FIG. 6** is shows a schematic representation of an assembly interface between two thermal solution devices (201, 202), such as metal heat spreaders and metal heat sinks, utilizing a liquefied diamond TIM coolant (203) within corresponding fins (204) between them.

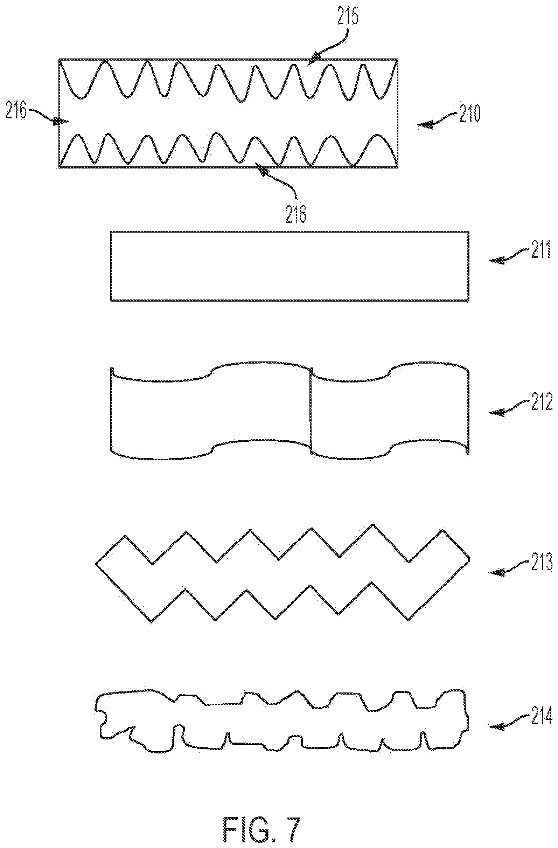

**FIG. 7** shows a schematic representation of various patterns (210, 211, 212, 213, 214) for filling voids between devices with liquified diamond TIM coolant. Example 210 shows the use of layers of liquified diamond TIM coolant (215) with a layer of metal foil (216) in between.

Although not depicted, adaptations of this design may include the application the liquefied diamond thermal interface material coolant between the CPU die and heat spreader or on both sides of the CPU processor to further enhance thermal energy dissipation. The liquefied diamond thermal interface material may also be used, for example, for the cooling of machinery, spacecraft components, and other applications.

### Temperature Delta Measurements (Liquefied Diamond TIM)

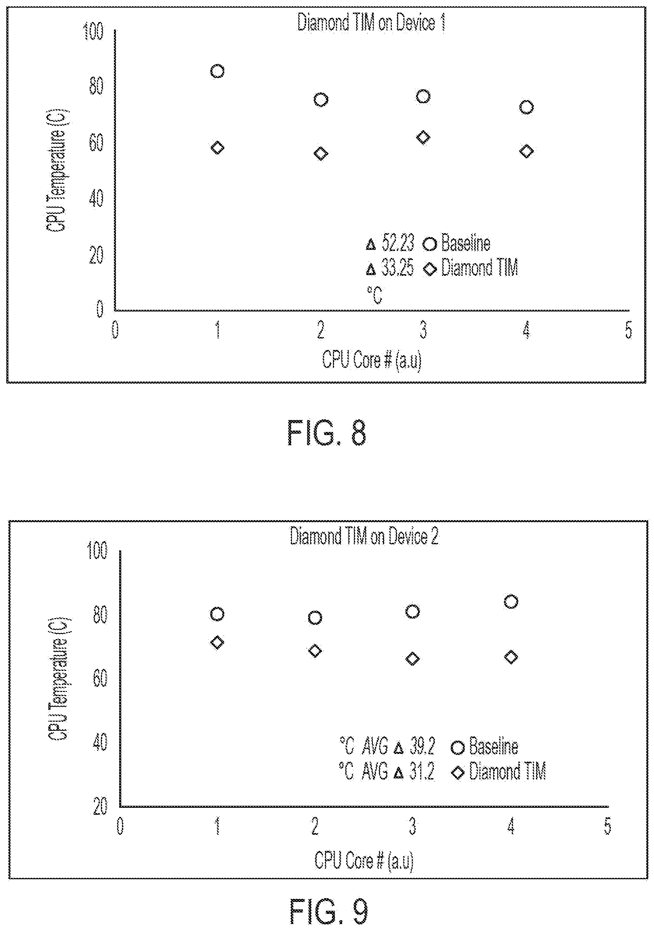

Shown in **FIGS. 8** and **9** is experimental data at ambient room temperature showing the effect of applying liquefied diamond TIM coolant between the CPU and the heat spreader for two separate devices.

As shown in **FIGS.8** and **9****,** the incorporation of liquefied diamond thermal interface coolant as thermal interface material decreases the average CPU temperature at various cores from 77 °C to 58 °C for device 1 and from 81 °C to 65 °C for device 2. The average delta for device 1 decreases from 52.23 °C to 33.25 °C and average delta for device 2 decreases from 39.2 °C to 31.2 °C. This corresponds to temperature delta reduction of 19 °C and 8 °C for device 1 and device 2 respectively.

### Nano Crystalline Diamond Encapsulation

The disclosed device comprises a non-conductive nano crystalline diamond layer encapsulated on the surface of the metal heat spreader in direct contact with the CPU or other heat source. The other side of the claimed heat spreader has a plurality of fins which mate with corresponding fins on a metal heat sink base. This design also allows for semiconducting wide-bandgap nano crystalline diamond layer for cooling components.

Diamond is a solid form of pure carbon allotrope with its atoms arranged in a diamond cubic crystal structure. The term nano crystalline diamond refers to diamond crystal having crystalline sizes in the nanometer range. Although the diamond encapsulated thickness may be up to several micrometers, since the crystal grain size within the nanometer scale, it is still considered nano crystalline diamond in the present disclosure.

The diamond encapsulated heat spreader can be made of refractory metal substrate such as molybdenum (Mo), tungsten (W), titanium alloy (TIAl4V6), platinum, and other metals that have low coefficient of thermal expansion and lattice match with respect to diamond crystal lattice.

The encapsulation process is achieved by microwave plasma chemical vapor deposition (CVD) technique. Typical growth conditions for the nano crystalline diamond deposition on metal substrates via plasma CVD consist of carbon gas precursor methane (CH₄) diluted in gas mixture of hydrogen (H₂), Argon (Ar), and nitrogen (N₂). Additional chemical dopant may include diborane (B₂H₆), phosphorus (P), and lithium (Li). The metal substrate is placed inside microwave plasma CVD vacuum chamber, exposed to plasma discharge with growth temperature between 400-800 °C, and grown at low pressure between 60-120 Torr.

The nano diamond carbon layer is deposited on the metal substrate per atomic layer over certain amount of time depending on the thickness of the coating layer. The methane concentration is generally within 1 to 5% (vol. %) over hydrogen gas mixture to maintain high quality diamond crystallinity sp³ over sp² graphite carbon structure. The surface roughness of the lab grown CVD diamond crystal is on the order of tens of nanometers.

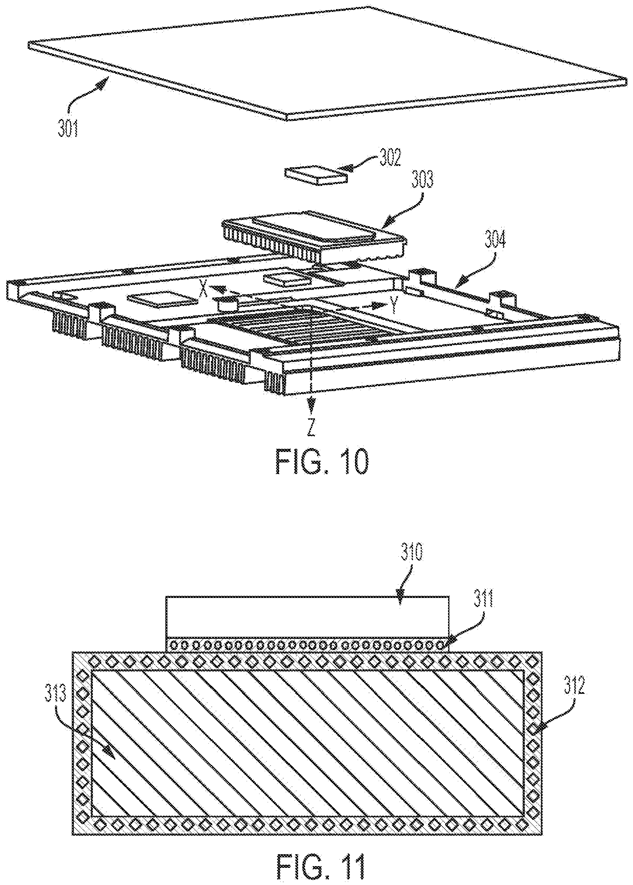

**FIG. 10** shows an exploded view of a PCB (301), CPU (302), nano crystalline diamond coated metal heat spreader (303), and metal heat sink base (304), in accordance with an embodiment of the present invention.

The nano crystalline diamond coated metal heat spreader (303) is placed between the CPU (302) and metal heat sink base (304). The nano crystalline diamond coated heat spreader (303) and heat sink base (304) can have a number of different cooperating geometries.

**FIG. 11** shows a schematic representation of an assembly interface between a CPU or other heat source (310), and a thermal solution device (313), such as a metal heat spreader or a metal heat sink, utilizing a layer of liquefied diamond TIM coolant (311) and a nano crystalline diamond coating layer (312) in accordance with an embodiment of the present invention.

As shown, an encapsulated layer of nano crystalline diamond material (312) is disposed over the surface of the thermal solution device (313). By encapsulating or impregnating the thermal solution device (313) with a nano crystalline diamond layer (312) using the process described above, the need for an additional thermal interface material on the thermal solution device (313) is eliminated. Moreover, thermal resistance between the two surfaces is reduced. Furthermore, local hot spots can be dissipated very rapidly from the heat source to the metal heat spreader and/or heat sink base which results in better heat transfer and thermal cooling. When the nano crystalline diamond layer (312) is combined with a layer of liquefied diamond TIM coolant (311), heat dissipation performance is exceptional.

## Claims

1. A metal heat spreader (313) for dissipating heat from an electronic component (110), comprising:
an outside surface; and
a nano crystalline diamond layer (312), wherein the outside surface of the metal heat spreader (313) is encapsulated by the nano crystalline diamond layer (312);
a first side that is in direct contact with the electronic component (110); and
a second side opposite to the first side and adapted to cooperate with a heat sink base (304) having a cooperating geometry, the second side having a plurality of fins (204) adapted to mate with a plurality of corresponding fins on the heat sink base (304).

2. The metal heat spreader (313) of claim 1, wherein the nano crystalline diamond layer comprises a plurality of diamond crystals having crystalline sizes in a nanometer range.

3. The metal heat spreader (313) of claim 1, wherein the nano crystalline diamond layer (312) is combined with a layer of liquefied diamond thermal interface material coolant.

4. The metal heat spreader (313) of claim 1, wherein the nano crystalline diamond layer (312) covers at least the first side of the heat spreader that is in direct contact with the electronic component.

5. The metal heat spreader (313) of claim 1, wherein the metal heat spreader is made of a refractory metal substrate.

## Patentansprüche

1. Metallwärmeverteiler (313) zur Wärmeableitung aus einem elektronischen Bauteil (110), umfassend:
eine Außenoberfläche; und
eine nanokristalline Diamantschicht (312), wobei die Außenoberfläche des Metallwärmeverteilers (313) durch die nanokristalline Diamantschicht (312) verkapselt ist;
eine erste Seite, die in direktem Kontakt mit dem elektronischen Bauteil (110) ist; und
eine zweite Seite, die der ersten Seite gegenüberliegt und dazu ausgelegt ist, mit einer Kühlkörperbasis (304), die eine zusammenwirkende Geometrie aufweist, zusammenzuwirken, wobei die zweite Seite eine Vielzahl von Rippen (204) aufweist, die dazu ausgelegt sind, mit einer Vielzahl von entsprechenden Rippen an der Kühlkörperbasis (304) zusammenzupassen.

2. Metallwärmeverteiler (313) nach Anspruch 1, wobei die nanokristalline Diamantschicht eine Vielzahl von Diamantkristallen umfasst, die Kristallgrößen in dem Nanometerbereich aufweisen.

3. Metallwärmeverteiler (313) nach Anspruch 1, wobei die nanokristalline Diamantschicht (312) mit einer Schicht aus einem Kühlmittel aus verflüssigtem Diamantwärmeleitmaterial kombiniert ist.

4. Metallwärmeverteiler (313) nach Anspruch 1, wobei die nanokristalline Diamantschicht (312) mindestens die erste Seite des Wärmeverteilers abdeckt, die in direktem Kontakt mit dem elektronischen Bauteil ist.

5. Metallwärmeverteiler (313) nach Anspruch 1, wobei der Metallwärmeverteiler aus einem Substrat aus hochschmelzendem Metall hergestellt ist.

## Revendications

1. Diffuseur thermique métallique (313) destiné à dissiper la chaleur d'un composant électronique (110), comprenant :
une surface extérieure ; et
une couche de diamant nanocristallin (312), dans lequel la surface extérieure du diffuseur thermique métallique (313) est encapsulée par la couche de diamant nanocristallin (312) ;
un premier côté qui est en contact direct avec le composant électronique (110) ; et
un second côté opposé au premier côté et adapté pour coopérer avec une base de dissipateur thermique (304) ayant une géométrie coopérative, le second côté ayant une pluralité d'ailettes (204) adaptées pour s'accoupler avec une pluralité d'ailettes correspondantes sur la base de dissipateur thermique (304).

2. Diffuseur thermique métallique (313) de la revendication 1, dans lequel la couche de diamant nanocristallin comprend une pluralité de cristaux de diamant ayant des tailles de cristallites de l'ordre du nanomètre.

3. Diffuseur thermique métallique (313) de la revendication 1, dans lequel la couche de diamant nanocristallin (312) est combinée avec une couche de liquide de refroidissement de matériau d'interface thermique en diamant liquéfié.

4. Diffuseur thermique métallique (313) de la revendication 1, dans lequel la couche de diamant nanocristallin (312) recouvre au moins le premier côté du diffuseur thermique qui est en contact direct avec le composant électronique.

5. Diffuseur thermique métallique (313) de la revendication 1, dans lequel le diffuseur thermique métallique est constitué d'un substrat métallique réfractaire.
